# EUROPÄISCHE PATENTSCHRIFT

(11) **EP 1 161 785 B1**
(45) Veröffentlichungstag und Bekanntmachung des Hinweises auf die Patenterteilung: **21.05.2003**
(21) Anmeldenummer: 00925046.5
(22) Anmeldetag: 15.03.2000
(51) Int. Cl.: H02B 1/30

(54) **SCHRANK ZUR AUFNAHME ELEKTRONISCHER BAUGRUPPEN UND VERTEILERKOMPONENTEN**
CABINET FOR RECEIVING ELECTRONIC SUB-ASSEMBLY AND DISTRIBUTION COMPONENTS
ARMOIRE DESTINEE A RECEVOIR DES MODULES ELECTRONIQUES ET COMPOSANTS DE DISTRIBUTION

(30) Priorität: 18.03.1999 DE 29904992 U
(43) Veröffentlichungstag der Anmeldung: 12.12.2001
(73) Patentinhaber: SIEMENS AKTIENGESELLSCHAFT, 80333 München (DE)
(72) Erfinder: NIGGL, Heinz-Jürgen, D-82343 Pöcking (DE); BUCHBERGER, Georg, D-81476 München (DE); SCHWIND, Stefan, D-82140 Olching (DE)
(74) Vertreter: Berg, Peter, Dipl.-Ing.
(86) Internationale Anmeldenummer: DE0000806
(87) Internationale Veröffentlichungsnummer: WO00057523

(56) Entgegenhaltungen:
- DE-U- 29 709 227
- DE-U- 29 711 262
- FR-A- 2 711 036

## Beschreibung

Die vorliegende Erfindung bezieht sich auf einen Schrank zur Aufnahme elektronischer Baugruppen und Verteilerkomponenten.

Aufgabe der Erfindung ist es, einen Schrank anzugeben, welcher leicht und kostengünstig herstellbar ist.

Die FR-A-2711036 beschreibt einen derartigen schrank bestehend aus vier senkrechten, jeweils oben und unten miteinander verbundenen stützen zur Befestigung der Baugruppen und Verteilerkomponenten.

Zur Lösung dieser Aufgabe besteht der erfindungsgemäße Schrank aus vier senkrechten, jeweils oben und unten miteinander verbundenen Stützen zur Befestigung der Baugruppen und Verteilerkomponenten, wobei die senkrechten Stützen jeweils einen schräg nach außen weisenden kammartig ausgebildeten Schenkel aufweisen, dessen äußere Kante jeweils eine Kante des Schranks bildet.

Der erfindungsgemäße Schrank besteht nur aus wenigen einfach herzustellenden Bauteilen, welche leicht zusammenfügbar sind.

Eine vorteilhafte Ausgestaltung des erfindungsgemäßen Schranks ist dadurch gekennzeichnet, daß der Querschnitt des Schranks quadratisch ist. Auf diese Weise können rundum gleiche Anbauteile, wie z.B. Türen, Zubehör, usw. verwendet werden.

Durch die vier Stützen ist auch der Einbau von niedrigen und schwereren Einbauten leicht möglich. Für die Stützen können einfachste Profile gewählt werden. Durch die kammartig nach außen weisenden ausgebildeten Schenkel ist eine fädelfreie Verdrahtung zwischen den einzelnen Einbauteilen möglich.

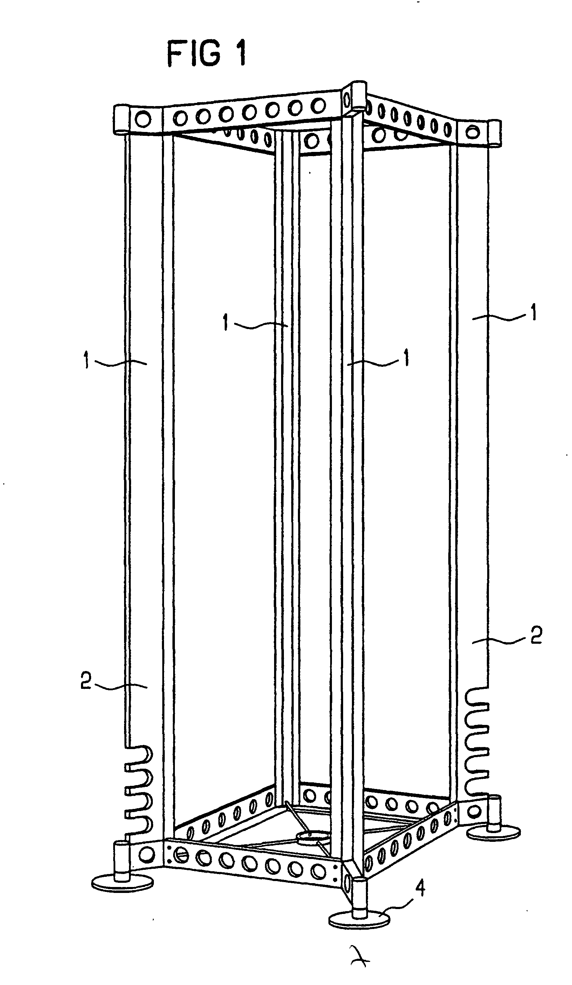

Weitere zweckmäßige Ausgestaltungen des erfindungsgemäßen Schranks ergeben sich aus den Unteransprüchen sowie aus der nachfolgenden Beschreibung eines Ausführungsbeispiels der Erfindung anhand der Zeichnung. Es zeigen
Figur 1 eine perspektivische Ansicht eines erfindungsgemäßen Schranks,

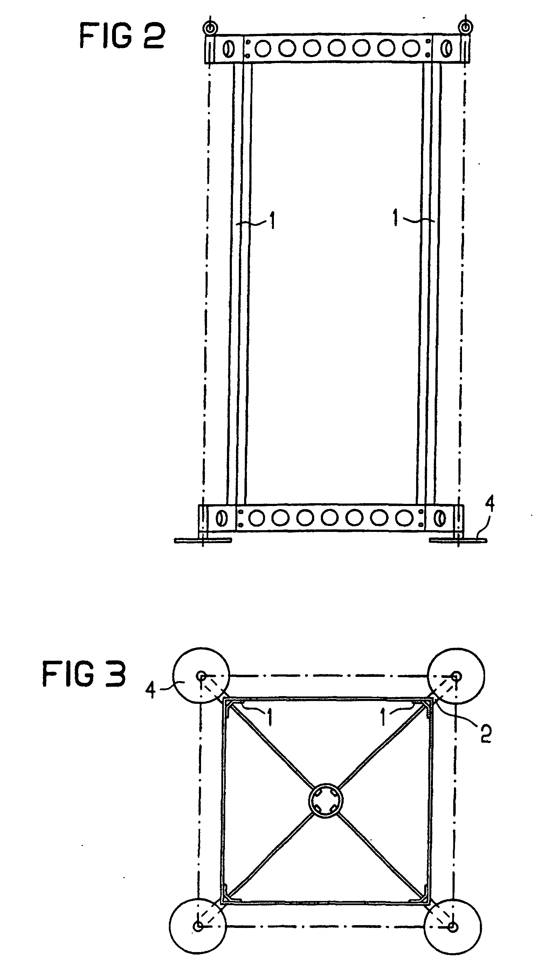

Figur 2 eine Seitenansicht des in Figur 1 dargestellten Schranks,
Figur 3 eine schematische Draufsicht auf den in Figur 1 dargestellten Schrank,
Figur 4 eine perspektivische Darstellung des erfindungsgemäßen Schranks, bei welcher die Verwendung von Türen angedeutet ist, und
Figur 5 Stellmöglichkeiten von mehreren erfindungsgemäßen Schränken.

Der Schrank gemäß der vorliegenden Erfindung besteht im wesentlichen aus den vier Stützen 1 mit den kammartig ausgebildeten Schenkeln 2. Die Stützen 1 sind oben und unten fest miteinander verbunden.

Die Stützen 1 bestehen aus einem Einfachstprofil, welches zur Befestigung der elektronischen Baugruppen bzw. zur Befestigung von Verteilerkomponenten dienen. Kleinere Baugruppen können jeweils an zwei Stützen 1 vorne und hinten befestigt werden. Es besteht aber aufgrund der vier Stützen auch die Möglichkeit niedrige und schwerere Einbauten ohne Probleme in den Schrank unterzubringen. Zur Befestigung können selbstfurchende Schrauben verwendet werden, wodurch gleichzeitig eine gute Erdung der Einbauten gesichert ist.

Besonders vorteilhaft ist ein quadratischer Querschnitt des Schranks, da auf diese Weise rundum gleiche Anbauteile verwendet werden können.

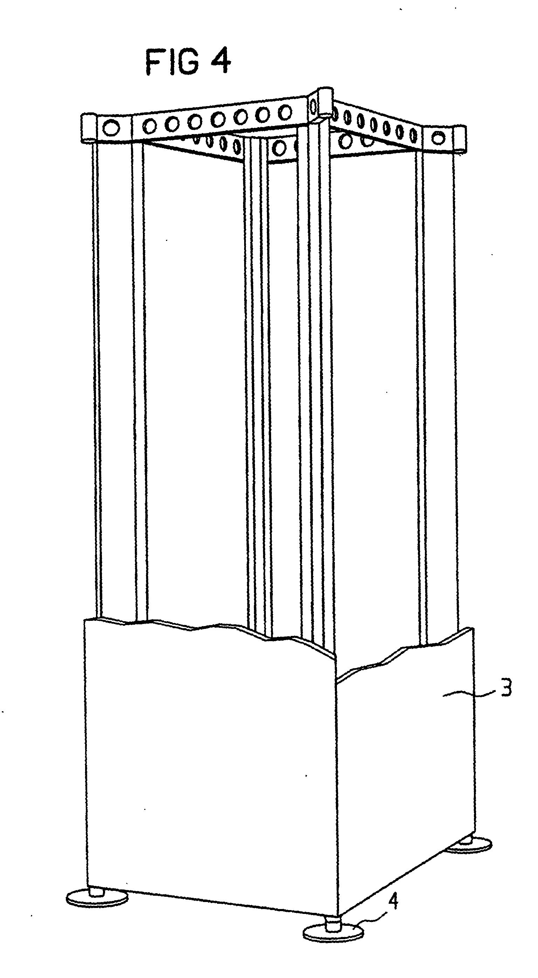

Der Schrank läßt sich, wie in Figur 4 angedeutet ist, mit Hilfe von Türen 3 verkleiden. Es besteht aber auch die Möglichkeit den Schrank nackt zu verwenden. Besonders vorteilhaft ist es, den Schrank auf Fußscheiben, die nach dem Tellerfeder-Prinzip aufgebaut sind, zu stellen.

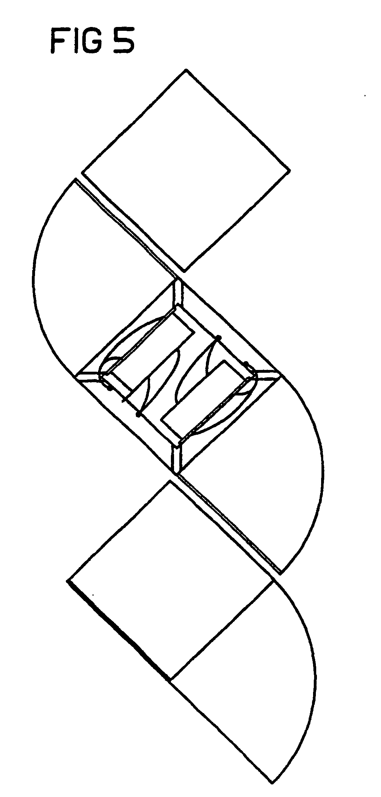

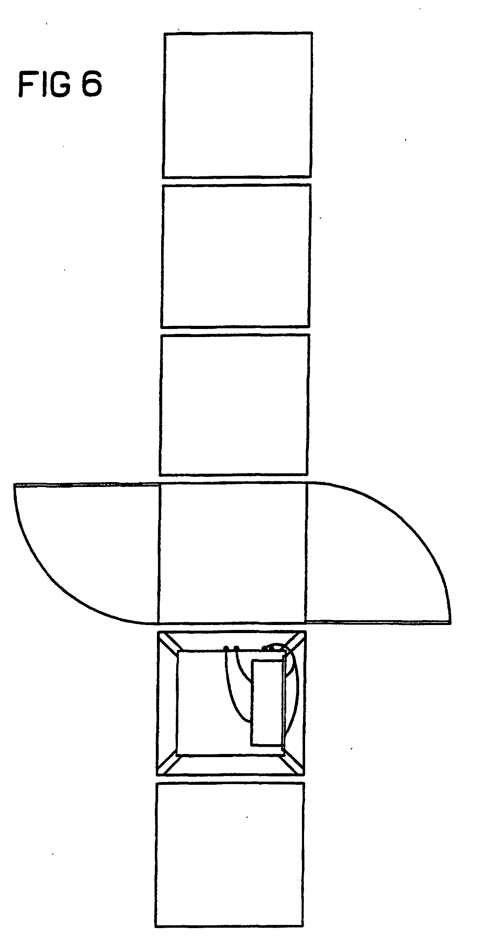

Der erfindungsgemäße Schrank ist von allen Seiten zugänglich, so daß es mehrere Möglichkeiten der Anordnung von mehreren Schränken gibt. In Figur 5 ist die Anordnung von mehreren Schränken dargestellt, bei welcher für jeden Schrank der Zugang von allen Seiten gegeben ist, während in Figur 6 eine Anordnung von mehreren Schränken dargestellt ist, bei welcher jeder Schrank lediglich von zwei Seiten zugänglich ist.

## Patentansprüche

1. Schrank zur Aufnahme elektronischer Baugruppen und Verteilerkomponenten, bestehend aus vier senkrechten, jeweils oben und unten miteinander verbundenen Stützen (1) zur Befestigung der Baugruppen und Verteilerkomponenten, wobei die senkrechten Stützen (1) jeweils einen schräg nach außen weisenden kammartig ausgebildeten Schenkel (2) aufweisen, dessen äußere Kante jeweils eine Kante des Schranks bildet.

2. Schrank nach Anspruch 1, **dadurch gekennzeichnet, daß** der Schrank einen quadratischen Querschnitt aufweist.

3. Schrank nach Anspruch 1 oder 2, **dadurch gekennzeichnet, daß** jede Stütze (1) oben und unten Scharniervorrichtungen für eine Tür (3) aufweist.

4. Schrank nach Anspruch 3, **dadurch gekennzeichnet, daß** der Schrank vier Türen aufweist.

## Claims

1. Cabinet for accommodating electronic subassemblies and distribution components, comprising four upright supports (1), which are connected to one another at the top and bottom in each case, for fixing the subassemblies and distribution components, the upright supports (1) each having a comb-like limb (2) that points obliquely outwards and whose outer edge in each case forms an edge of the cabinet.

2. Cabinet according to Claim 1, **characterized in that** the cabinet has a square cross section.

3. Cabinet according to Claim 1 or 2, **characterized in that**, at the top and bottom, each support (1) has hinge devices for a door (3).

4. Cabinet according to Claim 3, **characterized in that** the cabinet has four doors.

## Revendications

1. Armoire de réception de modules électroniques et de composants de distribution, constituée de quatre appuis (1) verticaux reliés entre eux respectivement en haut et en bas et destinés à la fixation des modules et des composants de répartition, les appuis (1) verticaux ayant respectivement une branche (2) qui est constituée à la manière d'un peigne tourné vers l'extérieur en étant incliné et dont le bord extérieur forme respectivement un bord de l'armoire.

2. Armoire selon la revendication 1, **caractérisée en ce que** l'armoire a une section transversale carrée.

3. Armoire selon la revendication 2, **caractérisée en ce que** chaque appui (1) a en haut et en bas des dispositifs de charnière pour une porte (3).

4. Armoire selon la revendication 3, **caractérisée en ce que** l'armoire a quatre portes.
